# EUROPÄISCHE PATENTSCHRIFT

(11) **EP 0 578 097 B1**
(45) Veröffentlichungstag und Bekanntmachung des Hinweises auf die Patenterteilung: **13.11.1996**
(21) Anmeldenummer: 93110317.0
(22) Anmeldetag: 29.06.1993
(51) Int. Cl.: H03K 19/018, H03K 19/00, H03K 17/60, H03K 17/66

(54) **Schaltstufe**
Switching stage
Etage de commutation

(30) Priorität: 06.07.1992 DE 4222170
(43) Veröffentlichungstag der Anmeldung: 12.01.1994
(73) Patentinhaber: SIEMENS AKTIENGESELLSCHAFT, 80333 München (DE)
(72) Erfinder: Barré, Claude, Dipl.-Ing., F-69003 Lyon (FR)

(56) Entgegenhaltungen:
- EP-A- 0 294 163
- US-A- 3 535 546
- US-A- 4 868 421
- PATENT ABSTRACTS OF JAPAN vol. 012, no. 174 (E-612)24. Mai 1988
- PATENT ABSTRACTS OF JAPAN vol. 14, no. 316 (E-949)(4259) 6. Juli 1990

## Beschreibung

Die Erfindung betrifft eine Schaltstufe mit einer Differenzverstärkeranordnung, der ausgangsseitig ein Emitterfolgertransistor nachgeschaltet ist, mit einer Stromquelle, die zwischen den Emitter des Emitterfolgertransistors und einen Anschluß für ein erstes Versorgungspotential geschaltet ist, mit einem Ausgang, mit einem Widerstand, dessen erster Anschluß mit dem Emitter des Emitterfolgertransistors und dessen zweiten Anschluß mit dem Ausgang verbunden ist, und mit einem Anschluß für ein zweites Versorgungspotential, der mit dem Kollektor des Emitterfolgertransistors verbunden ist.

Solche Schaltstufen sind z.B. aus US-A-3 535 546 bekannt und werden beispielsweise als Ausgangstreiber in integrierten Schaltungen eingesetzt, die in Stromschaltertechnik realisiert sind. Der Ausgang der Schaltstufe wird mit einer Signalleitung verbunden, die auf einer Leiterplatte angeordnet ist. Das andere Ende der Signalleitung ist mit der Basis eines Eingangstransistors einer weiteren Schaltstufe verbunden. Bei einem Umschaltvorgang fließt durch den Widerstand ein Strom, durch den die Kapazitäten der Signalleitung umgeladen werden. Beim Ubergang von einem L- zu einem H-Pegel fließt der Strom durch den Widerstand vom Emitter des Emitterfolgertransistors zum Ausgang der Schaltstufe. Beim Ubergang von einem H- zu einem L-Pegel fließt der Strom in umgekehrter Richtung. Im ersten Fall wird der Strom vom Emitterfolgertransistor geliefert, der zusätzlich noch den von der Stromquelle eingeprägten Strom führt. Im zweiten Fall fließt der Strom durch den Widerstand über die Stromquelle. Da die Stromquelle ständig, also auch während des Ruhezustandes der Schaltstufe den von ihr eingeprägten Strom liefert, ist die Verlustleistung hoch.

Die Aufgabe der Erfindung ist es, eine Schaltstufe der beschriebenen Art so weiterzubilden, daß die Verlustleistung niedrig ist.

Die Aufgabe der Erfindung wird dadurch gelöst, daß
(a) die Stromquelle steuerbar ist und einen Steuereingang aufweist,
(b) ein Mittel vorhanden ist, das mit dem ersten und dem zweiten Anschluß des Widerstandes und dem Anschluß für das erste Versorgungspotential verbunden ist,
(c) das Mittel einen Ausgang aufweist, der ein Signal führt, das von der Polarität der am Widerstand abfallenden Spannung abhängig ist,
(d) die Stromquelle mit ihrem Steuereingang mit dem Ausgang des Mittels verbunden ist und so gesteuert wird, daß durch sie ein hoher Strom fließt, wenn der erste Anschluß des Widerstandes auf negativerem Potential liegt als der zweite Anschluß des Widerstandes, und ein geringer Strom fließt, wenn der erste Anschluß des Widerstandes auf positiverem Potential liegt als der zweite Anschluß des Widerstandes.

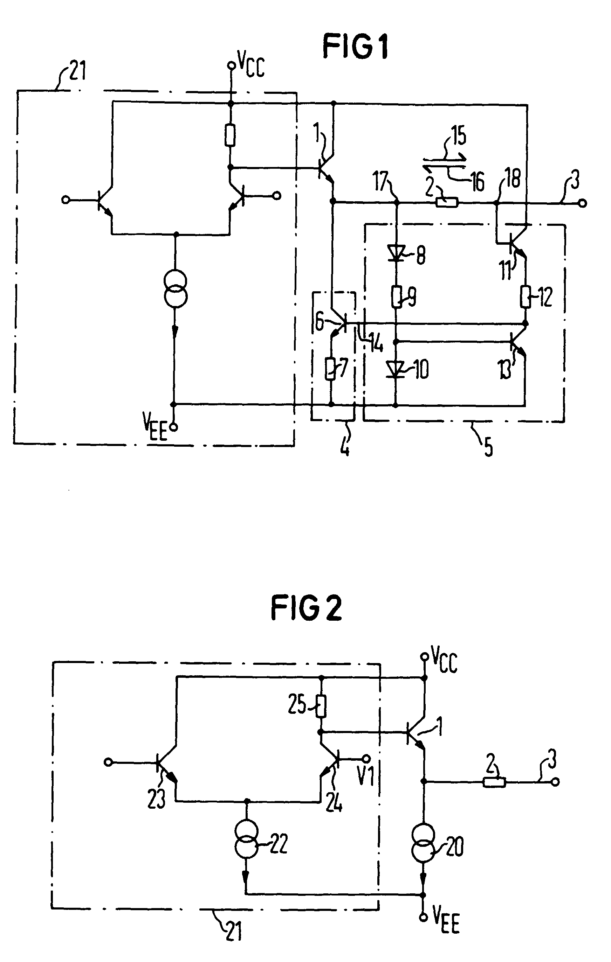

Die Erfindung wird im folgenden anhand der in den Figuren gezeigten Ausführungsbeispiele erläutert. Es zeigen FIG 1 eine erfindungsgemäße Schaltstufe und FIG 2 eine Schaltstufe nach dem Stand der Technik.

Die bekannte Schaltstufe der FIG 2 enthält eine als Stromschalter arbeitende Differenzverstärkeranordnung 21 mit einer nachgeschalteten Ausgangstreiberstufe. Die Differenzverstärkeranordnung 21 enthält zwei emittergekoppelte Bipolartransistoren 23, 24, die an ihren Emittern über eine Stromquelle 22 mit einem Anschluß für ein erstes Versorgungspotential VEE verbunden sind. Der Kollektor des Bipolartransistors 23 ist direkt, der Kollektor des Bipolartransistors 24 über einen Widerstand 25 mit einem Anschluß für ein weiteres Versorgungspotential VCC verbunden. Die Basis des Transistors 23 wird von einem Eingangssignal gesteuert, und die Basis des Bipolartransistors 24 liegt an einem Anschluß für ein Referenzpotential V1. Als Ausgang des Stromschalters dient der Kollektor des Bipolartransistors 24. Ihm ist ein Emitterfolgertransistor 1 nachgeschaltet, dessen Kollektor mit dem Anschluß für das Versorgungspotential VCC und dessen Emitter über eine Stromquelle 20 mit dem Anschluß für das Versorgungspotential VEE verbunden ist. Der Emitter des Emitterfolgertransistors 1 ist über einen Widerstand 2 mit einem Ausgang 3 der Schaltstufe verbunden. Der Ausgang 3 dient zum Anschluß an eine Leiterbahn auf einer Leiterplatte. Das andere Ende der Leiterbahn ist üblicherweise mit der Basis eines Eingangstransistors einer weiteren Schaltstufe verbunden.

Im Ruhezustand der Schaltstufe fließt durch den Widerstand 2 der Basisstrom des Eingangstransistors der weiteren Schaltstufe. Bei einem Umschalten von einem L- zu einem H-Pegel oder von einem H- zu einem L-Pegel verschiebt sich das Potential am Emitter des Emitterfolgertransistors 1 um den am Widerstand 25 abfallenden Signalpegelhub. Der Widerstand 2 ist so bemessen, daß er dem Wellenwiderstand der am Ausgang angeschlossenen Leitung entspricht. Das andere Ende der Leitung wirkt deshalb als Leerlauf. Während des Umschaltens von L nach oder von H nach L fließt durch den Widerstand 2 ein relativ hoher Strom, durch den die Leitungskapazitäten umgeladen werden. Der Basisstrom des nachgeschalteten Eingangstransistors ist im Vergleich zu diesem Strom vernachlässigbar. Da der Widerstand 2 den Wert des Wellenwiderstandes der Leitung hat, steigt bzw. fällt der am Ausgang 3 anliegende Pegel anfangs nur um die Hälfte des Pegelhubes. Die sich längs der Leitung ausbreitende Welle wird am als Leerlauf wirkenden anderen Ende reflektiert. Sie überlagert sich dann dem am Ausgang 3 bereits anliegenden Pegel. Somit resultiert der H- bzw. L-Pegel am Ausgang 3 erst dann, wenn die Hin- und Rücklaufzeit der Welle längs der Leitung verstrichen ist. Während dieser Zeit fließt der Strom durch den Widerstand 2.

Im Fall des Übergangs von einem L- zu einem H-Pegel am Emitter des Emitterfolgertransistors 1 fließt der Strom durch den Widerstand 2 vom Emitter des Emitterfolgertransistors 1 in Richtung 15 des Ausgangs 3. Dieser Strom wird vom Emitterfolgertransistor 1 geliefert, der zusätzlich noch den Strom durch die Stromquelle 20 aufnimmt. Für den Übergang von einem H- zu einem L-Pegel fließt der Strom durch den Widerstand 2 in umgekehrter Richtung 16 vom Ausgang 3 zum Emitter des Emitterfolgertransistors 1. Dieser Strom fließt zusammen mit einem geringen Strom durch den Emitterfolgertransistor 1 durch die Stromquelle 20 zum Versorgungspotential VEE. Der Strom durch die Stromquelle 20 fließt ständig, also auch im Ruhezustand der Schaltstufe und unabhängig von der Richtung des Pegelübergangs. Die Verlustleistung ist dadurch hoch.

In der FIG 1 ist eine erfindungsgemäße Realisierung einer Schaltstufe gezeigt. Der Emitter des Emitterfolgertransistors 1 ist über eine gesteuerte Stromquelle 4 mit dem Anschluß für das Versorgungspotential VEE verbunden. Der mit dem Emitterfolgertransistor 1 verbundene Anschluß und der ausgangsseitige Anschluß 18 des Widerstandes 2 sind mit einer Schaltung 5 verbunden. Durch die Schaltung 5 wird die Polarität der am Widerstand 2 abfallenden Spannung und somit die Richtung 15 oder 16 des Stromflusses bestimmt. Ein Ausgang 14 der Schaltung 5 ist mit der Basis des Bipolartransistors 6 verbunden und steuert den Strom der Stromquelle 4. Am Ausgang 14 liegt ein hoher Pegel an, wenn der Strom durch den Widerstand 2 in Richtung 15 fließt. Durch die Stromquelle 4 wird ein hoher Strom eingeprägt, so daß der Strom durch den Widerstand 2 über die Stromquelle 4 zum Versorgungspotential VEE fließt. Für einen Strom in Richtung 16 ist der Pegel am Ausgang 14 niedrig. Dadurch prägt die Stromquelle 4 einen niedrigen Strom ein. Der Emitterfolgertransistor 1 liefert den Strom, der durch den Widerstand 2 in Richtung 16 des Ausgangs 3 fließt. Die Schaltstufe hat den Vorteil, daß die Stromquelle 4 nur dann einen hohen eingeprägten Strom liefert, wenn der Strom durch den Widerstand 2 in Richtung 15 fließt. Dadurch ist die Verlustleistung verringert.

Die Schaltung 5 enthält einen ersten Strompfad, der die Reihenschaltung einer ersten Diode 8, eines ersten Widerstandes 9 und einer zweiten Diode 10 enthält. Die Anode der Diode 8 ist mit dem Anschluß 17 des Widerstandes 2 verbunden, die Kathode der Diode 10 ist mit dem Anschluß für das Versorgungspotential VEE verbunden. Der Widerstand 9 ist zwischen den Dioden 8, 10 angeordnet. Ein zweiter Strompfad enthält die Reihenschaltung der Basis-Emitter-Strecke eines ersten Bipolartransistors 11, eines zweiten Widerstandes 12 und der Kollektor-Emitter-Strecke eines dritten Bipolartransistors 13. Die Basis des Bipolartransistors 11 ist mit dem ausgangsseitigen Anschluß 18 des Widerstandes 2 verbunden. Der Emitter des Bipolartransistors 13 ist mit dem Anschluß für das Versorgungspotential VEE verbunden. Der Widerstand 12 ist zwischen den Emitter des Bipolartransistors 11 und den Kollektor des Bipolartransistors 13 geschaltet. Die Basis des Bipolartransistors 13 ist mit der Anode der Diode 10 verbunden, so daß aus der Diode 10 und dem Bipolartransistor 13 eine Stromspiegelschaltung gebildet wird. Als Ausgang 14 der Schaltung 5 dient der Kollektor des Bipolartransistors 13. Der Kollektor des Bipolartransistors 11 ist wahlweise mit dem eingangsseitigen Anschluß des Widerstandes 2 oder dem Kollektor des Emitterfolgertransistors 1 verbunden.

In dem Fall, daß der Strom durch den Widerstand 2 vom Ausgangs 3 in Richtung 15 des Emitterfolgertransistors 1 fließt, liegt der ausgangsseitige Anschluß 18 des Widerstandes 2 auf höherem Potential als sein anderer Anschluß 17. Dadurch wird das Potential am Kollektor des Bipolartransistors 13 und somit das Potential an der Basis des Stromquellentransistors 6 angehoben. Im anderen Fall liegt das Potential des Kollektors des Bipolartransistors 13 niedrig, so daß der Stromquellentransistor 6 nahezu gesperrt ist. Der Strompfad aus der Diode 8, dem Widerstand 9 und der Diode 10 ist so dimensioniert, daß nur ein geringer Strom fließt. Dadurch wird der als Konstantstromquelle geschaltete Transistor 13 leitend gesteuert und an der Basis-Emitter-Strecke des Emitterfolgertransistors 1 bei einem L-Pegel eine Vorspannung bewirkt, so daß parasitäre Kapazitäten nicht vollständig umgeladen werden.

## Patentansprüche

1. Schaltstufe mit einer Differenzverstärkeranordnung (21), der ausgangsseitig ein Emitterfolgertransistor (1) nachgeschaltet ist, mit einer Stromquelle (4) die zwischen den Emitter des Emitterfolgertransistors (1) und einen Anschluß für ein erstes Versorgungspotential (VEE) geschaltet ist, mit einem Ausgang (3), mit einem Widerstand (2), dessen erster Anschluß (17) mit dem Emitter des Emitterfolgertransistors (1) und dessen zweiten Anschluß (18) mit dem Ausgang (3) verbunden ist, und mit einem Anschluß für ein zweites Versorgungspotential (VCC), der mit dem Kollektor des Emitterfolgertransistors (1) verbunden ist,
**dadurch gekennzeichnet**, daß
(a) die Stromquelle (4) steuerbar ist und einen Steuereingang (14) aufweist,
(b) ein Mittel (5) vornanden ist, das mit dem ersten und dem zweiten Anschluß (17, 18) des Widerstandes (2) und dem Anschluß für das erste Versorgungspotential (VEE) verbunden ist,
(c) das Mittel (5) einen Ausgang aufweist, der ein Signal führt, das von der Polarität der am Widerstand (2) abfallenden Spannung abhängig ist, und
(d) die Stromquelle (4) mit ihrem Steuereingang (14) mit dem Ausgang des Mittels (5) verbunden ist und so gesteuert wird, daß durch sie ein hoher Strom fließt, wenn der erste Anschluß (17) des Widerstandes auf negativerem Potential liegt als der zweite Anschluß (18) des Widerstandes, und ein geringer Strom fließt, wenn der erste Anschluß (17) des Widerstandes auf positiverem Potential liegt als der zweite Anschluß (18) des Widerstandes (2).

2. Schaltstufe nach Ansprucn 1, **dadurch gekennzeichnet,** daß die gesteuerte Stromquelle (4) einen Bipolartransistor (6) und einen Widerstand (7) enthält und der Kollektor des Bipolartransistors (6) mit dem Emitter des Emitterfolgertransistors (1) und der Emitter des Bipolartransistors (6) über den Widerstand (7) mit dem Anschluß für das erste Versorgungspotential (VEE) verbunden ist und die Basis des Bipolartransistors als der Steuereingang (14) der Stromquelle (4) dient.

3. Schaltstufe nach Ansprucn 1, **dadurch gekennzeichnet,** daß
(a) das Mittel (5) einen ersten und einen zweiten Bipolartransistor (11, 13), eine erste und eine zweite Diode (8, 10) und einen ersten und einen zweiten Widerstand (9, 1 ) enthält,
(b) die erste Diode (8) mit ihrer Anode mit dem ersten Anschluß des Widerstandes (2) und die Kathode der zweiten Diode (10) mit dem Anschluß für das erste Versorgungspotential (VEE) verbunden ist,
(c) zwischen der Kathode der ersten Diode (8) und der Anode der zweiten Diode (10) der erste Widerstand (9) angeordnet ist,
(d) die Basis des ersten Bipolartransistors (11) mit dem zweiten Anschluß des Widerstandes (2) und der Emitter des zweiten Bipolartransistors (13) mit dem Anschluß für das erste Versorgungspotential (VEE) verbunden ist,
(e) zwischen dem Emitter des ersten Bipolartransistors (11) und dem Kollektor des zweiten Bipolartransistors (13) der zweite Widerstand (12) angeordnet ist,
(f) die Basis des zweiten Bipolartransistors (13) mit der Anode der zweiten Diode (10) verbunden ist,
(g) der Kollektor des ersten Bipolartransistors (11) entweder mit dem ersten Anschluß (17) des Widerstandes (2) oder mit dem Anschluß für das zweite Versorgungspotential (VCC) verbunden ist,
(h) der Kollektor des zweiten Bipolartransistors (13) als Ausgang des Mittels dient.

## Claims

1. Switching stage having a differential amplifier arrangement (21), which has connected downstream of it on the output side an emitter follower transistor (1), having a current source (4) which is connected between the emitter of the emitter follower transistor (1) and a connection for a first supply potential (VEE), having an output (3), having a resistor (2) whose first connection (17) is connected to the emitter of the emitter follower transistor (1) and whose second connection (18) is connected to the output (3), and having a connection for a second supply potential (VCC) which is connected to the collector of the emitter follower transistor (1), characterized in that
(a) the current source (4) is controllable and has a control input (14),
(b) a means (5) is provided which is connected to the first and to the second connection (17, 18) of the resistor (2) and to the connection for the first supply potential (VEE),
(c) the means (5) has an output which carries a signal which is dependent on the polarity of the voltage drop across the resistor (2), and
(d) the control input (14) of the current source (4) is connected to the output of the means (5) and is controlled such that a high current flows through it when the first connection (17) of the resistor is at a more negative potential than the second connection (18) of the resistor, and a low current flows when the first connection (17) of the resistor is at a more positive potential than the second connection (18) of the resistor (2).

2. Switching stage according to Claim 1, characterized in that the controlled current source (4) contains a bipolar transistor (6) and a resistor (7), and the collector of the bipolar transistor (6) is connected to the emitter of the emitter follower transistor (1), and the emitter of the bipolar transistor (6) is connected via the resistor (7) to the connection for the first supply potential (VEE), and the base of the bipolar transistor is used as the control input (14) of the current source (4).

3. Switching stage according to Claim 1, characterized in that
(a) the means (5) contains a first and a second bipolar transistor (11, 13), a first and a second diode (8, 10) and a first and a second resistor (9, 1),
(b) the anode of the first diode (8) is connected to the first connection of the resistor (2), and the cathode of the second diode (10) is connected to the connection for the first supply potential (VEE),
(c) the first resistor (9) is arranged between the cathode of the first diode (8) and the anode of the second diode (10),
(d) the base of the first bipolar transistor (11) is connected to the second connection of the resistor (2), and the emitter of the second bipolar transistor (13) is connected to the connection for the first supply potential (VEE),
(e) the second resistor (12) is arranged between the emitter of the first bipolar transistor (11) and the collector of the second bipolar transistor (13),
(f) the base of the second bipolar transistor (13) is connected to the anode of the second diode (10),
(g) the collector of the first bipolar transistor (11) is connected either to the first connection (17) of the resistor (2) or to the connection for the second supply potential (VCC),
(h) the collector of the second bipolar transistor (13) is used as the output of the means.

## Revendications

1. Etage de commutation comportant un dispositif (21) d'amplificateur différentiel, en aval de la sortie duquel est branché un transistor (1) émetteur suiveur, une source (4) de courant, qui est branchée entre l'émetteur du transistor (1) émetteur suiveur et une borne pour un premier potentiel (VEE) d'alimentation, une sortie (3), une résistance (2), dont la première borne (17) est reliée à l'émetteur du transistor (1) émetteur suiveur et dont la seconde borne (18) est reliée à la sortie (3), et une borne pour un second potentiel (VCC) d'alimentation, qui est reliée au collecteur du transistor (1) émetteur suiveur,
caractérisé en ce que
a) la source (4) de courant peut être commandée et comporte une entrée (14) de commande,
b) il est prévu un moyen (5) qui est relié à la première et à la seconde borne (17, 18) de la résistance (2) et à la borne pour le premier potentiel (VEE) d'alimentation,
c) le moyen (5) comporte une sortie qui conduit un signal dépendant de la polarité de la chute de tension aux bornes de la résistance (2) et
d) la source (4) de courant est reliée par son entrée (14) de commande à la sortie du moyen (5) et est commandée, de manière qu'il passe par elle un courant grand, lorsque la première borne (17) de la résistance est à un potentiel plus négatif que la seconde borne (18) de la résistance et qu'il y passe un courant petit, lorsque la première borne (17) de la résistance est à un potentiel plus positif que la seconde borne (18) de la résistance (2).

2. Etage de commutation suivant la revendication 1, caractérisé en ce que la source (4) commandée de courant comprend un transistor bipolaire (6) et une résistance (7) et le collecteur du transistor bipolaire (6) est relié à l'émetteur du transistor émetteur suiveur (1) et l'émetteur du transistor bipolaire (6) est relié par l'intermédiaire de la résistance (7) à la borne pour le premier potentiel (VEE) d'alimentation et la base du transistor bipolaire sert d'entrée (14) de commande de la source (4) de courant.

3. Etage de commutation suivant la revendication 1, caractérisé en ce que
a) le moyen (5) comprend des premier et second transistors bipolaires (11, 13), des première et seconde diodes (8, 10) et des première et seconde résistances (9, 1),
b) la première diode (8) est reliée par son anode à la première borne de la résistance (2) et la cathode de la seconde diode (10) est reliée à la borne pour le premier potentiel (VEE) d'alimentation,
c) la première résistance (9) est disposée entre la cathode de la première diode (8) et l'anode de la seconde diode (10),
d) la base du premier transistor bipolaire (11) est reliée à la seconde borne de la résistance (2) et l'émetteur du second transistor bipolaire (13) est relié à la borne pour le premier potentiel (VEE) d'alimentation,
e) il est disposé entre l'émetteur du premier transistor bipolaire (11) et le collecteur du second transistor bipolaire (13) la seconde résistance (12),
f) la base du second transistor bipolaire (13) est reliée à l'anode de la seconde diode (10),
g) le collecteur du premier transistor bipolaire (11) est relié soit à la première borne (17) de la résistance (2), soit à la borne pour le second potentiel (VCC) d'alimentation,
h) le collecteur du second transistor bipolaire (13) sert de sortie du moyen.
